Europäisches Patentamt

European Patent Office

Office européen des brevets

(11) Veröffentlichungsnummer: **0 162 126**
**A2**

## (12) EUROPÄISCHE PATENTANMELDUNG

(21) Anmeldenummer: **84108727.3**

(22) Anmeldetag: **24.07.84**

(51) Int. Cl.⁴: **H 01 R 9/09**
**H 05 K 3/40**

(30) Priorität: **22.05.84 DE 3418959**

(43) Veröffentlichungstag der Anmeldung:
**27.11.85 Patentblatt 85/48**

(84) Benannte Vertragsstaaten:
**DE FR GB NL**

(71) Anmelder: **NIPPON MEKTRON, LTD.**
**12-15, 1-Chome Shiba Daimon**
**Minato-ku Tokyo(JP)**

(72) Erfinder: **Kameda, Eiichi**
**806-189 Ushiku Apt. 102 Ushiku-Machi**
**Inashiki-Gun Ibaraki-Ken, 300-12(JP)**

(72) Erfinder: **Tobe, Seiichi**
**807-31 Ushiku-Machi Inashiki-Gun**
**Ibaraki-Ken, 300-12(JP)**

(74) Vertreter: **Weissenfeld-Richters, Helga, Dr.**
**Höhnerweg 2**
**D-6940 Weinheim/Bergstrasse(DE)**

(54) **Kontaktstift für übereinanderliegende Schaltkreiselemente.**

(57) Für Stapel aus mit ihren Anschlußbereichen übereinanderliegenden, flächigen Schaltkreiselementen wird zwecks elektrischer Kontaktierung sowie Zusammenhaltes des Verbundes ein neuartiger, leitfähiger Kontaktstift vorgeschlagen, der längs seiner Achse an der Außenseite mindestens eine durchgehende, gerippte oder gezahnte Kante aufweist. Der erfindungsgemäße Kontaktstift schneidet mit dieser scharfen Kante beim Einsetzen in eine senkrechte, durchgehende Kontaktbohrung des Schaltkreisstapels in die lochwand ein und stellt somit eine äußerst feste und sichere elektrische und mechanische Verbindung der einzelnen Elemente untereinander her. Ferner gelingt es aufgrund der dirigierenden Funktion der erfindungsgemäßen Rippen, ein Lötmittel vollständig in den verbleibenden Hohlraum der Bohrung einzufüllen.

FIG. 3

-1-

Kontaktstift für übereinanderliegende
Schaltkreiselemente

Die Erfindung betrifft einen Kontaktstift zum elektrischen
und mechanischen Verbinden mindestens zweier übereinanderliegender elektrischer Schaltkreiselemente.

Ein Schaltkreiselement der hier angesprochenen Art besteht aus einem platten- oder folienartigen Träger aus
isolierendem Material, auf welchem Leiterbahnen fixiert
sind.

Diese Leiterbahnen werden ihrerseits durch einen aufgebrachten Isolierstoff geschützt. Ferner besitzt jedes Schaltkreiselement einen sogenannten Anschlußbereich, in den alle Leiterbahnen einmünden und womit weitere elektronische Bauteile elektrisch angeschlossen werden können.

Die Forderung nach extrem hoher Leiterdichte auf engstem Raum macht es notwendig, mehrere dieser Schaltkreise aufeinanderzustapeln, wobei die Anschlußbereiche übereinander zu liegen kommen. Die elektrische und mechanische Verbindung der Einzelelemente erfolgt dadurch, daß diese mit ihren in den Kontaktbereichen vorhandenen Bohrungen exakt übereinandergelegt werden, oder indem zuerst der Stapel gefertigt wird und anschließend durch diesen im Kontaktflächenbereich der Einzelelemente eine oder mehrere Bohrungen hindurchgeführt werden. In diese Bohrungen eingezogene Nieten oder Hohlnieten stellen dabei den elektrischen Kontakt senkrecht zu den Leiterebenen her und halten den Verbund mechanisch zusammen, unterstützt durch in die Bohrungen zusätzlich eingefülltes Lötmittel.

Geeignete Kontaktstücke sind in DE-AS 26 24 666 als Stand der Technik genannt. Infolge seiner besonderen Fließeigenschaften und des raschen Erstarrens vermag das erwähnte Lot jedoch oft nicht den gesamten Bohrungsraum auszufüllen, was Unterbrechungen in der elektrischen Leitfähigkeit senkrecht zu den Leiterschichten zur Folge haben kann. Ferner wird häufig der Kontaktniet nicht vollständig vom Lotmaterial umgeben, so daß auch die mechanische Festigkeit des Leiterebenen-Verbundes oft den gestellten Anforderungen nicht genügt.

Die erwähnte Auslegeschrift schlägt nun als Lösung dieser Problematik vor, zunächst an den einzelnen Plattenelementen in den Anschlußbereichen Bohrungen vorzusehen, diese mit Lotpfropfen auszufüllen, inmitten des erstarrten Lotes ein engeres Loch herzustellen, die Schaltkreiselemente mit sich deckenden Bohrungen aufeinanderzulegen, ein nietartiges, mit einem Anschlag versehenes Kontaktstück in diese Bohrungen einzustecken und es jenseits des untersten Schaltkreises zu vernieten. Hierzu werden konische Kontaktstücke vorgeschlagen, welche zumindest bereichsweise hohl sind.

Diese Vorgehensweise mag zu einem dauerhaften Verbund der Elemente des Schaltkreisstapels führen; das Einfüllen der Lotpfropfen jedoch und das erneute, mittige Aufbohren des Lotes erfordern nicht nur eine sehr exakte Arbeitsweise, sondern auch, wie der Anspruch 1 der Auslegeschrift verdeutlicht, etliche separate Arbeitsschritte, was einer kostengünstigen Massenfertigung entgegensteht sowie qualifiziertes Personal und Arbeitsgeräte mit hoher Präzision erfordert.

Die Anmelderin hat sich daher die Aufgabe gestellt, mit einem neuartigen Kontaktstück die Fertigung von Schaltkreisstapeln auf der Basis Kontaktlochung wesentlich zu vereinfachen, ohne die oben genannten Verluste an elektrischer und mechanischer Verbindung der Elemente untereinander in Kauf nehmen zu müssen. Ferner wurde die Aufgabe gestellt, dieses Kontaktstück so auszugestalten, daß es beim Einfüllen des Lötmittels in die Bohrung als Fließhilfe zwecks allseitiger Benetzung und Füllung fungiert.

Als Lösung wird ein Kontaktstift gemäß dem kennzeichnenden Teil des Anspruchs 1 vorgeschlagen. Dieser Stift besitzt mindestens eine Längskante mit scharfen Rippen oder Zähnen, welche sich über die gesamte Länge des Stiftes erstreckt. Der Kontaktstift besitzt, über diese Kante gemessen, einen Durchmesser, der etwas größer ist als der weiteste Durchmesser der zugehörigen Kontaktbohrung des Leiterplattenstapels. Die Rippe schneidet daher beim Einsetzen des Stiftes in die Peripherie der Bohrung ein und bewirkt somit einen sicheren elektrischen sowie mechanischen Kontakt zwischen dem Stift und den Anschlußbereichen der einzelnen Schaltkreisebenen.

Diese Lösung schafft die Möglichkeit, nach dem Einsetzen des Kontaktstückes auf einfache Weise Lötmittel in die Bohrung einfließen zu lassen, wobei der Stift als Fließhilfe dient, um das Lot an alle zugänglichen Leiterbereiche im Innern der Bohrung fließen zu lassen. Hierdurch wird zusätzlich ein allseitiger, guter elektrischer Kontakt gewährleistet.

Der Querschnitt des erfindungsgemäßen Kontaktstiftes kann vorzugsweise mehreckig gestaltet sein, wodurch eine besonders sichere Verankerungsmöglichkeit in der Bohrung gegeben ist und Raum für das einzubringende Lötmittel gewonnen wird. Solche mehreckigen Anschlußstifte sind zwar prinzipiell aus DE-OS 25 24 581 bekannt; sie dienen dort aber ausschließlich zum Verbinden von an ihnen unter einem Winkel anliegenden Anschlußlappen aus Kernmaterial, welche beim bewußt unvollständigen Ausstanzen der Kontaktlöcher entstehen.

Für ein solches Verfahren ist zudem ein kompliziertes Mehrzweckwerkzeug erforderlich.

Die vorliegende Erfindung wird anhand der beigefügten Zeichnungen näher erläutert.

Dabei zeigt

Fig. 1 einen vergrößerten Querschnitt durch eine Bohrung in den Anschlußflächen von aufeinanderliegenden elektrischen Schaltkreisen, bevor der erfindungsgemäße Kontaktstift eingesetzt ist;

Fig. 2 den Zustand der Komponenten von Figur 1 nach dem Einsetzen des erfindungsgemäßen Kontaktstiftes;

Fig. 3 eine Aufsicht gemäß Figur 2;

Fig. 4 einen Querschnitt entlang der Linie IV-IV in Figur 3 nach Einführung des Lötmittels in die Bohrung;

Fig. 5 die perspektivische Darstellung einer bevorzugten Ausführung des erfindungsgemäßen Kontaktstiftes;

Fig. 6 die perspektivische Darstellung einer weiteren bevorzugten Ausführung des erfindungsgemäßen Kontaktstiftes.

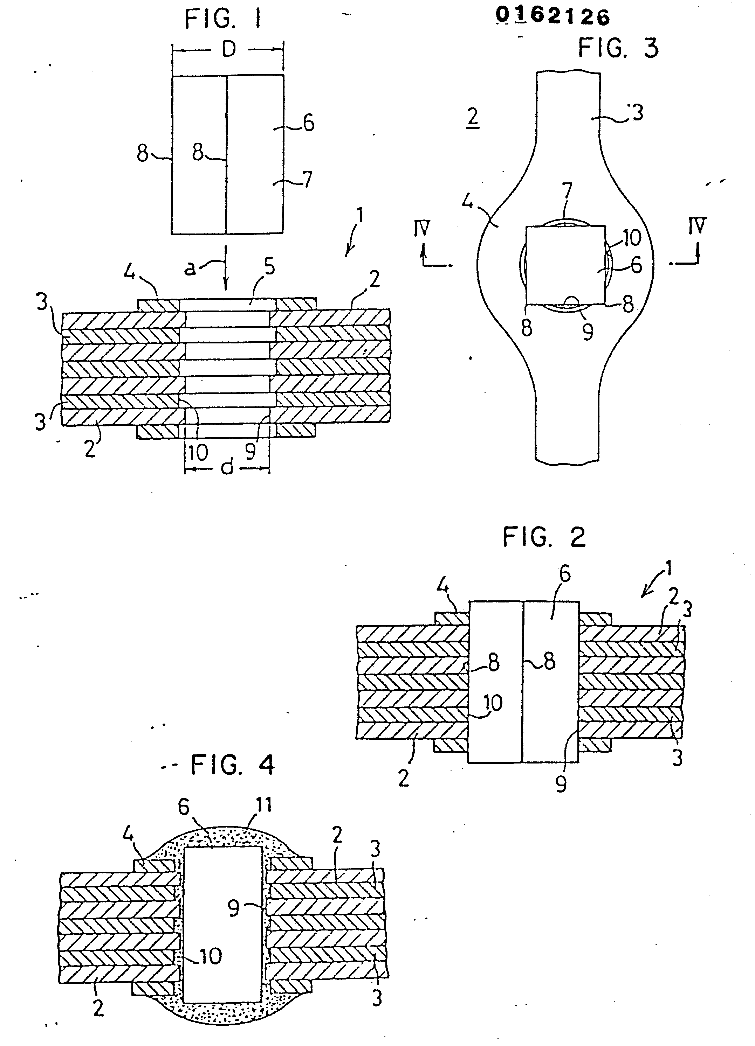

In Figur 1 ist mit 1 der Stapel mehrerer übereinanderliegender einzelner Schaltkreiselemente bezeichnet. Jedes dieser Elemente besteht aus einer Isolier- bzw. Basisschicht 2 mit einem gedruckten Leiterbahnen-Muster 3. Eine vertikale Bohrung 5 durchdringt den gesamten Schaltkreisstapel. Die Umgebung der Lochstelle 5 wird als Anschlußbereich 4 des Leitersystems 3 bezeichnet. Die Wandungen 10 der Leiterbahnen 3 sollten dabei, wie gezeichnet, etwas weiter auseinanderliegen als diejenigen der Isolierschicht 2, so daß diese Wandungen 9 jeweils etwas in den Lochraum hineinragen. Ein Kontaktstift 6 aus elektrisch leitendem Material, für gewöhnlich aus Metall, wird in Richtung des Teiles a in die Bohrung 5 eingetrieben. Bei dieser speziellen Ausführungsform besitzt der in der Bohrung befindliche Bereich des Kontaktstiftes 6 die Form einer quadratischen Säule mit 4 längs verlaufenden, mit Spitzen oder Rippen versehenen Zonen 8 an den Außenkanten der Umfangsflächen 7. Der längste Durchmesser D des Kontaktstiftes 6 ist dabei etwas größer als der innere Durchmesser d der Bohrung 5 bei 9 und auch geringfügig größer als der Lochdurchmesser im Bereich 10. Dadurch schneidet der Stift mit seinen scharfen Kanten in die Innenwandungen 9 und 10 der Bohrung 5 ein, was ihm einen festen Sitz verschafft und einen über alle Anschlußbereiche 4 hinweg sicheren elektrischen Kontakt bewirkt (Figur 2).

Die Flächen 7 des Kontaktstiftes 6 liegen, wie Figur 3 und 4 verdeutlichen, nicht an den Innenflächen der Bohrung 5 an.

Es verbleibt somit genügend Raum, in den nach dem Einsetzen des Stiftes 6 ein Lot 11 aus einem Schwall- oder Tauchbad eingefüllt wird, wie dies in DE-OS 25 24 581 bei einer anderen Kontaktmethode bereits beschrieben ist. Die Rippen des Stiftes 6 leiten dabei das flüssige Lötmaterial zuverlässig durch die gesamte Bohrung bis hin zu den Wandungsbereichen 9 und 10, so daß die Hohlräume zwischen den Flächen 7 des Stiftes 6 und den die Bohrung umschließenden Schaltkreisabschnitten 9 und 10 so vollständig gefüllt sind, daß zusammen mit dem Einschneiden der gezahnten Rippen in die Lochwände auf einfachste Weise ein in diesem Maße bisher nicht erzielbarer, umfassender und dauerhafter elektrischer Kontakt hergestellt wird unter gleichzeitiger Gewährleistung eines auch unter hoher mechanischer Beanspruchung nahezu unzerstörbaren Schaltkreis-Verbundes.

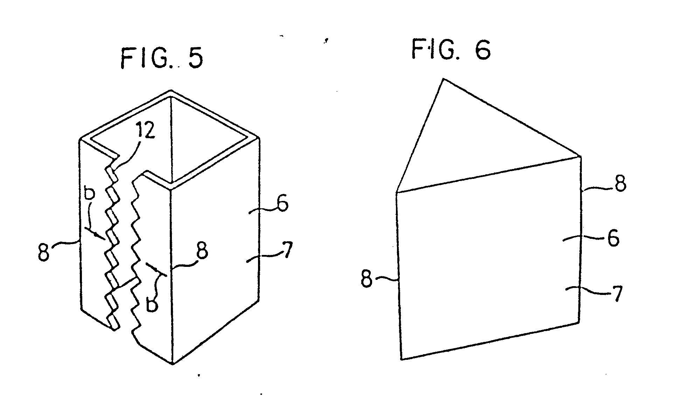

Eine andere, beispielhafte Form des erfindungsgemäßen Kontaktstiftes 6 zeigt Figur 5. Er ist im vorliegenden Falle als quadratischer Hohlstift ausgebildet und besitzt an einer seiner Außenflächen einen parallel zu seiner Längsachse verlaufenden, beidseitig gezahnten, durchgehenden Schlitz 12. Mit dieser bevorzugten Ausführungsform ist es möglich, den Stift 6 während des Einsetzens in die Bohrung 5 etwas in Richtung b zusammenzudrücken, worauf er sich mit den gerippten oder gezahnten Kanten 8 wegen seiner Aufspreiztendenz nach dem Einbau fest an die Lochwandungen anlegt.

Figur 6 schließlich zeigt einen massiven Stift 6 mit dreieckigem Querschnitt, dessen Kanten 8 wiederum gerippt
oder gezahnt sind. Diese Ausführungsform läßt nach dem
Einbau besonders viel Raum für Lötmittel.

Selbstverständlich kann jede geeignet erscheinende,erfindungsgemäße Stiftform verwendet werden, sofern der
Kontaktstift wenigstens eine gerippte oder gezahnte
Längskante aufweist.

Bezugszeichenliste

1   Schaltkreisstapel

2   Isolier- bzw. Basisschicht

3   Leiterbahn

4   Anschlußbereich des Leiterbahnensystems

5   durchgehende Bohrung durch den Schaltkreisstapel 1

6   Kontaktstift

7   Umfangsfläche des Kontaktstiftes 6

8   Umfangskante des Kontaktstiftes 6 mit Rippen oder Zähnen

9   Lochwandung der Isolierschicht 2

10  Lochwandung der Leiterbahnen 3

11  Lötmittel, Lot

12  gezahnter Längsschlitz

a   Einführungsrichtung des Kontaktstiftes 6 in die Bohrung 5

b   Richtung des Zusammendrückens eines hohlen Kontaktstiftes mit Längsschlitz vor dem Einsetzen

d   Lochdurchmesser der Isolier- oder Basisschichten 2

D   größter Durchmesser des Kontaktstiftes 6

Ansprüche:

1. Kontaktstift, ausgebildet als Hohl- oder Massivteil aus elektrisch leitfähigem Material, zum elektrischen und mechanischen Verbinden der Anschlußbereiche mindestens zweier übereinanderliegender elektrischer Schaltkreiselemente unter Einbeziehung eines Lötmittels, wobei der eine durchgehende Bohrung im Anschlußbereich der Schaltkreiselemente durchdringende Stiftkörper mindestens die Länge dieser Bohrung aufweist, sie jedoch im Querschnitt nur teilweise ausfüllt, dadurch gekennzeichnet, daß sich auf der Außenseite (7) des in die Bohrung einzuführenden Teiles des Kontaktstiftes (6) mindestens eine parallel zu dessen Längsachse durchgehend verlaufende Kante (8) befindet, welche mit scharfen Rippen oder Zähnen versehen ist, und daß der Kontaktstift (6) - über die Kante (8) gemessen - einen Durchmesser aufweist, der etwas größer ist als der weiteste Durchmesser der Bohrung (5).

2. Kontaktstift nach Anspruch 1, dadurch gekennzeichnet, daß sein die Bohrung (5) durchdringender Bereich die Form einer massiven quadratischen Säule mit vier Kanten (8) aufweist.

3. Kontaktstift nach Anspruch 1, dadurch gekennzeichnet, daß sein die Bohrung (5) durchdringender Bereich die Form einer massiven Dreieckssäule aufweist.

4. Kontaktstift nach Anspruch 1 bis 3, dadurch gekennzeichnet, daß sein die Bohrung (5) durchdringender
Bereich als Hohlstift ausgebildet ist, der an einer
Seite (7) mit einem parallel zu seiner Längsachse
verlaufenden, durchgehenden, beidseitig gezahnten
Längsschlitz (12) versehen ist.

5. Kontaktstift nach Anspruch 1 bis 4, dadurch gekennzeichnet, daß sämtliche Kanten (8) scharf gerippt
oder gezahnt sind.

FIG. 1

FIG. 3

0162126

FIG. 2

FIG. 4

FIG. 5

FIG. 6